# FASCICULE DE BREVET EUROPEEN

(11) **EP 0 864 179 B1**
(45) Date de publication et mention de la délivrance du brevet: **08.03.2006**
(21) Numéro de dépôt: 97943021.2
(22) Date de dépôt: 29.09.1997
(51) Int. Cl.: H01L 31/18, H01L 31/109, H01L 27/146

(54) **DETECTEUR DE RAYONNEMENT PHOTONIQUE DE GRANDES DIMENSIONS**
STRAHLUNGSDETEKTOR MIT GROSSEN ABMESSUNGEN
PHOTONIC RADIATION SENSOR OF LARGE DIMENSIONS

(30) Priorité: 01.10.1996 FR 9611937
(43) Date de publication de la demande: 16.09.1998
(73) Titulaire: COMMISSARIAT A L'ENERGIE ATOMIQUE, 75015 Paris (FR)
(72) Inventeur: DESTEFANIS, Gérard, F-38120 Saint-Egrève (FR); WOLNY, Michel, F-38000 Grenoble (FR)
(74) Mandataire: Poulin, Gérard
(86) Numéro de dépôt international: PCT/FR1997/001714
(87) Numéro de publication internationale: WO 1998/015016

(56) Documents cités:
- FR-A- 2 612 335
- KWAK N J ET AL: "HG0.8CD0.2TE GROWN BY LIQUID PHASE EPITAXY USING CD0.94ZN0.06TE BUFFER LAYER" JOURNAL OF CRYSTAL GROWTH, vol. 138, no. 1/04, 2 avril 1994, pages 950-955, XP000474560
- BUBULAC L O ET AL: "DIFFUSION OF AS AND SB IN HGCDTE" JOURNAL OF CRYSTAL GROWTH, vol. 123, no. 3 / 04, 1 octobre 1992, pages 555-566, XP000328229
- DESTEFANIS G L: "HGCDTE INFRARED DIODE ARRAYS" SEMICONDUCTOR SCIENCE AND TECHNOLOGY, vol. 6, no. 12C, 1 décembre 1991, pages C88-C92, XP000247934 cité dans la demande
- KAWAHARA A ET AL: "Hybrid 256*256 LWIR FPA using MBE grown HgCdTe on GaAs" INFRARED TECHNOLOGY XXI, SAN DIEGO, CA, USA, 9-13 JULY 1995, vol. 2552, pt.1, ISSN 0277-786X, PROCEEDINGS OF THE SPIE - THE INTERNATIONAL SOCIETY FOR OPTICAL ENGINEERING, 1995, SPIE-INT. SOC. OPT. ENG, USA, pages 411-420, XP000646077 cité dans la demande
- HARMAN: "Controlled p-type Sb doping in LPE grown Hg(1-x)Cd(x)Te epilayers" JOURNAL OF ELECTRONIC MATERIALS, vol. 22, no. 9, 1993, pages 1165-1172, XP000646076 cité dans la demande

## Description

### Domaine technique

La présente invention concerne un détecteur de rayonnement photonique de grandes dimensions.

### Etat de la technique antérieure

Les détecteurs infrarouges de hautes performances actuellement les plus employés sont basés sur une technique d'hybridation d'une puce de détection sur une puce de lecture via un réseau de microbilles (par exemple à base d'indium) assurant l'interconnexion électrique et mécanique des deux puces.

Le circuit de lecture qui permet de lire les signaux détectés par chaque pixel et de les multiplexer sur une seule sortie ou un petit nombre de sorties, est un circuit analogique à base de silicium. La complexité de ces circuits (taille, densité, caractère analogique) empêche, en effet, d'envisager raisonnablement toute autre technologie pour les réaliser.

La puce de détection est généralement constituée d'un grand nombre de pixels disposés selon une structure bidimensionnelle ou mosaïque à ixj pixels (par exemple 128×128, 256×256, 640×480 pixels) ou éventuellement selon une structure unidimensionnelle ou quasi-unidimensionnelle à ixj pixels avec i=1 ou i<<j (par exemple 288×4, 480×4 pixels). Pour réaliser des composants de hautes performances, le matériau de détection le plus couramment employé est un alliage CdₓHg₁₋ₓTe (0 ≤ x ≤ 1) épitaxié par une quelconque technique (LPE, MBE, MOVPE, ISOVPE, etc..) sur un substrat de Cd_{1-z}Zn_{z}Te (0 ≤ z ≤ 1) adapté en paramètre de maille. Le composant élémentaire photosensible consiste en une diode N/P réalisée dans la couche de CdHgTe.

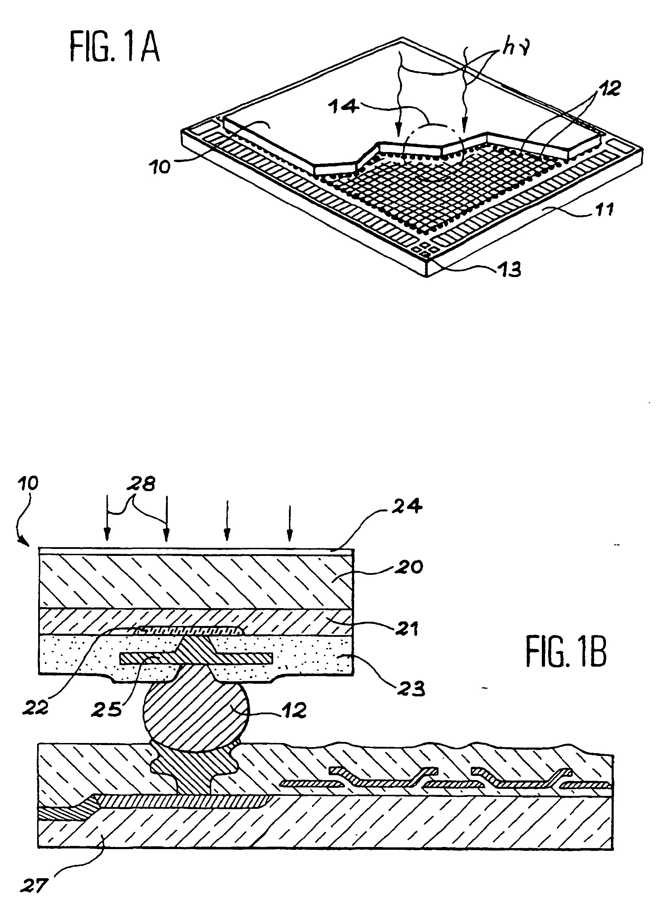

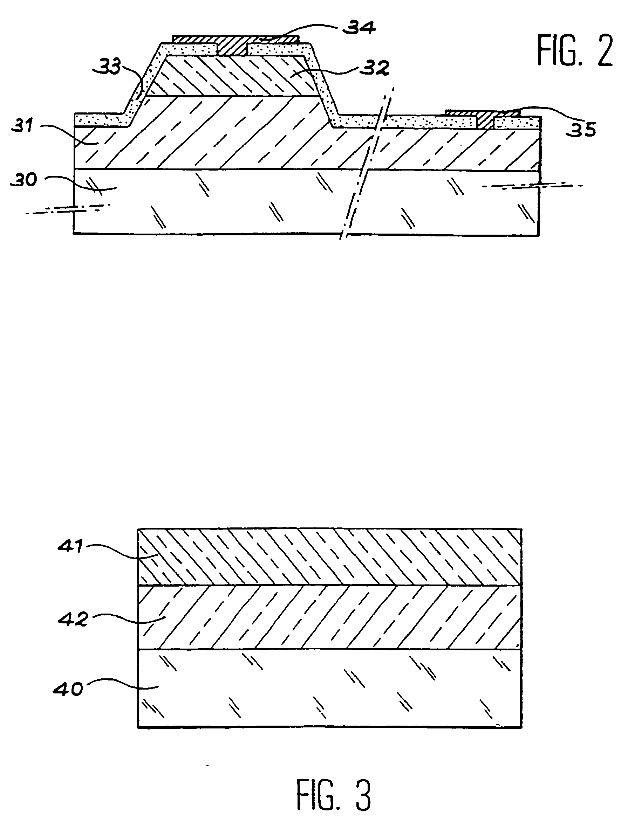

Plusieurs variantes technologiques existent pour fabriquer ces jonctions. La technique actuellement la plus mature est basée sur un procédé planaire utilisant une implantation ionique pour former la jonction, comme décrit dans les documents référencés [1] ou [2] en fin de description. On peut souligner que si la prise de contact sur la zone N se fait au niveau de chaque pixel, celle sur la zone P est usuellement commune à toutes les diodes élémentaires constituant le dispositif. Comparativement à d'autres technologies, celle-ci offre de nombreux avantages liés essentiellement à sa relative simplicité qui induit une très bonne reproductibilité/fiabilité : absence de gravures pour définir les surfaces actives, empilement métallurgique simple (cette structure nécessite une seule couche alors qu'au moins deux couches sont nécessaires pour les structures à hétérojonction), moindre sensibilité du niveau de bruit basse fréquence des détecteurs à la polarisation du dispositif. La robustesse et la fiabilité de cette technologie sont démontrées par le fait que les composants ainsi fabriqués ont été les premiers à être disponibles industriellement. De plus il a été récemment montré que l'on pouvait obtenir le même niveau de courant d'obscurité dans ces structures dans lesquelles une jonction matériau N sur matériau P est formée, comme illustré sur les figures 1A et 1B et décrit dans le document référencé [3], que dans les structures à hétérojonction où la zone P se situe au-dessus de la zone N, comme illustré sur la figure 2.

En effet, les figures 1A et 1B illustrent respectivement une vue schématique d'un détecteur de rayonnement infrarouge bidimensionnel hybridé sur son circuit de lecture ainsi qu'un agrandissement d'un pixel montrant une coupe d'un élément de détection.

Sur la figure 1A sont représentés notamment une puce détectrice 10, un circuit 11 en silicium, et des connexions métalliques 12 (microbilles d'indium par exemple), le signal vidéo étant obtenu en 13.

La figure 1B correspond à un agrandissement de la partie référencée 14 sur la figure 1A. Sur cette figure sont représentés un substrat CdZnTe 20, une couche de CdHgTe 21, une diode N/P 22 réalisée dans cette couche 21, une couche de passivation 23, une couche anti-reflet 24, un contact 25, une microbille d'indium 12, un circuit en silicium 27, le rayonnement reçu 28 étant une illumination infrarouge.

La figure 2 illustre un détecteur à hétérojonction « P sur N » comprenant une couche substrat CdZnTe 30 surmontée d'une couche détectrice de type N 31 de CdₓHg₁₋ₓTe, d'une couche détectrice de type P 32 de Cd_{y}Hg_{1-y}Te avec y>x, et une couche de passivation 33. Sur cette figure 2 sont également représentés un contact pixel 34, et un contact « substrat » 35, commun à tous les pixels, qui est situé en bout de mosaïque.

Actuellement le besoin en circuits bidimensionnels à très grand nombre de pixels, par exemple de format supérieur ou égal à 256x256 éléments, est de plus en plus pressant. Avec ces composants lorsque l'on cherche à détecter un signal important, comme c'est par exemple le cas dans le mode caméra thermique opérant dans la bande 8-12 µm et en observation d'une scène à une température voisine de 300 K, or peut assister, notamment: dans les structures planaires N sur P, à un phénomène de dépolarisation des diodes situées loin des prises de contacts, dites « contacts substrat » dans la suite de la description, qui se trouvent usuellement en bord de matrice, et qui sont communes à tous les pixels de la matrice comme indiqué ci-dessus. Ce phénomène peut s'avérer très gênant pour faire fonctionner le dispositif et peut même le rendre inutilisable. Il est lié à la valeur de la résistance d'accès à ces diodes du centre du composant. Dans le cas des structures planaires N sur P, cette résistance d'accès est déterminée par les propriétés de transport de la zone P de la couche 21 de CdHgTe (dopage typique dans la gamme de quelques 10¹⁶ cm⁻³, mobilité typique des porteurs (trous) dans la gamme 300-500 cm²/V/s) ainsi évidemment qu'à la taille du composant.

Pour remédier à ce problème, certaines solutions « évidentes » peuvent être proposées. Parmi celles-ci on peut considérer un contact substrat (i.e., dans le cas des structures planaires sur la zone P de la couche 21 de CdHgTe) au voisinage de chaque diode ou de chaque groupe de diodes, de taille suffisamment restreinte pour éviter tout problème de dépolarisation. Ceci implique toutefois une diminution du facteur de remplissage de la mosaïque, et donc une baisse de sa performance, soit au niveau de chaque pixel soit au niveau de chaque groupe de pixels, ainsi qu'une complexité technologique accrue (connectique entre tous les contacts substrats). Une autre solution consiste à augmenter l'épaisseur de la couche 21 de CdHgTe par rapport à la couche habituellement utilisée (épaisseur e₀) et donc celle de la zone P qui subsiste après implantation ionique des zones N, dans le cas des structures planaires N sur P. Là encore la performance du dispositif est dégradée : soit le rendement quantique diminue (par exemple si e₀ est supérieure à la longueur de diffusion des porteurs minoritaires), soit le courant d'obscurité augmente (si e₀ est inférieure à la longueur de diffusion des porteurs minoritaires), soit les deux (si e₀ est inférieure à la longueur de diffusion des porteurs minoritaires et si l'épaisseur finale de la couche est supérieure à la longueur de diffusion des porteurs minoritaires). Dans tous les cas le rapport entre le courant photonique et le courant d'obscurité diminue.

Ce problème de résistance d'accès se présente à un niveau beaucoup moins important dans les structures à hétérojonction qui utilisent une structure P sur N, comme illustré sur la figure 2, et qui bénéficient des excellentes propriétés de conduction des couches de type N liées à la très haute mobilité des électrons dans ces couches ; dans ces structures c'est cette couche de type N qui assure le contact substrat commun à toutes les diodes. Toutefois cette technologie présente de sérieux inconvénients par rapport à la technologie « planaire » N sur P.

Le document référencé [8] décrit une photodiode HgCdTe à réponse rapide, qui est réalisée dans une couche de semiconducteur HgCdTe de type P. Sur une face de cette couche est formée une zone dopée de type N. Une métallisation est en contact avec une couche de semimétal HgTe, disposée sur l'autre face de la couche de semiconducteur HgCdTe, en regard de la jonction PN.

Le document référencé [9] décrit un procédé d'amélioration des propriétés électriques d'une structure Hg_{0.8}Zn_{0.06}Te à croissance par épitaxie en phase liquide en insérant une couche tampon de Cd_{0.94}Zn_{0.06}Te entre la couche épitaxiée Hg_{0.8}Cd_{0.2}Te et le substrat Cd_{0.97}Zn_{0.03}Te.

L'invention a pour objet de pallier le problème de résistance série élevée rencontré sur les diodes fabriquées avec la technologie planaire décrite ci-dessus et situées au centre de grandes mosaïques bidimensionnelles à ixj pixels (i et j étant grands, par exemple supérieurs à 128) destinées à détecter un fort niveau de signal, tout en permettant de conserver les caractéristiques électro-optiques des détecteurs.

### Exposé de l'invention

La présente invention concerne un détecteur de rayonnement photonique bidimensionnel basé sur une technique d'hybridation d'une puce de détection sur une puce de lecture via un réseau de microbilles assurant l'interconnexion électrique et mécanique des deux puces, la puce de détection étant constituée d'une structure bidimensionnelle de ixj pixels, une couche active disposée sur un substrat, chaque composant élémentaire photosensible consistant en une diode N/P ou P/N réalisée dans la couche active, la prise de contact sur la zone N ou P se faisant au niveau de chaque pixel, la prise de contact sur l'autre zone P ou N étant commune à toutes les diodes, caractérisé en ce qu'il comprend une couche intermédiaire de plus grand gap que celui de la couche active, cette couche intermédiaire étant transparente optiquement pour les longueurs d'onde que l'on cherche à détecter, et neutre au niveau électrique assurant une contribution négligeable de la couche intermédiaire au courant d'obscurité du détecteur, cette couche intermédiaire étant déposée sur le substrat, la couche active étant déposée sur cette couche intermédiaire, la couche active et la couche intermédiaire étant des couches de CdHgTe de composition différentes, la couche intermédiaire étant une couche de Cd_{y}Hg_{1-y}Te telle que y < 1.

Avantageusement la couche active est une couche de CdₓHg₁₋ₓTe, avec 0 ≤ × ≤ 1, le substrat est une couche de Cd_{1-z}Zn_{z}Te, avec 0 ≤ z ≤ 1, et la couche intermédiaire est une couche de Cd_{y}Hg_{1-y}Te, transparente pour les longueurs d'ondes que l'on cherche à détecter : x + ε < y < 1, avec ε > 0, où x est la composition de la couche de CdₓHg₁₋ₓTe qui compose 1a couche active. On peut choisir Xₘₐₓ < y, où Xₘₐₓ serait la composition d'une couche CdHgTe dont le gap est égal à hc/qλₘᵢₙ (h : constante de Planck ; c : vitesse de la lumière ; q : charge de l'électron ; λₘᵢₙ : longueur d'onde minimale qui l'on cherche à détecter), la longueur d'onde maximale à détecter étant définie par le gap de la couche de CdₓHg₁₋ₓTe. De plus, y est préférentiellement choisi inférieur à Xₘₐₓ + 0.1 de manière à conserver un excellent accord de maille entre le substrat, la couche intermédiaire et le reste de la structure (zone optiquement active).

Avantageusement l'épaisseur de la couche intermédiaire est comprise entre 10 et 30 µm.

Dans une première variante de l'invention cette couche est dopée par écart à la stoechiométrie.

Dans une seconde variante cette couche est dopée extrinsèquement de type P avec une impureté. Préférentiellement une impureté diffusant peu dans CdHgTe, par exemple As ou Sb, est employée.

La présente invention trouve des applications dans :
- la détection de rayonnement ;
- la détection de rayonnement infrarouge dans la gamme 3-30 µm, en particulier dans les fenêtres de transmission atmosphérique 3-5 µm et 8-12 µm ;
- l'imagerie thermique.

### Brève description des dessins

- Les figures 1A et 1B illustrent respectivement une vue schématique d'un détecteur de rayonnement infrarouge bidimensionnel de l'art antérieur, hybride sur son circuit de lecture, et un agrandissement d'un pixel montrant une coupé d'un élément de détecteur ;
- la figure 2 illustre une vue schématique en coupe d'un détecteur à hétérojonction « P sur N » de l'art antérieur ;
- la figure 3 illustre un empilement multicouche employé dans le détecteur de l'invention.

### Exposé détaillé de modes de réalisation

L'invention consiste à insérer entre le substrat en CdZnTe 40 et la couche active de CdₓHg₁₋ₓTe 41 d'un détecteur tel que celui illustré sur la figure 1, une couche de Cd_{y}Hg_{1-y}Te 42 transparente optiquement et électriquement, cette couche 42 étant une couche à grand gap (ou largeur de bande interdite) et la couche active 41 de CdₓHg₁₋ₓTe étant une couche à faible gap.

Une telle structure se compose d'une couche 42 de Cd_{y}Hg_{1-y}Te déposée sur un substrat 40 de Cd_{1-z}Zn_{z}Te par une quelconque technique d'épitaxie, cette couche étant elle-même surmontée de la couche active 41 de CdₓHg₁₋ₓTe réalisée par une quelconque technique d'épitaxie, préférentiellement la même que celle employée pour la couche de Cd_{y}Hg_{1-y}Te (mais cela n'est pas nécessaire). La figure 3 illustre l'empilement métallurgique ainsi réalisé.

Préférentiellement l'hétérojonction formée par la juxtaposition de matériaux CdHgTe de compositions différentes présente une gradualité suffisante de manière à éviter la présence d'une éventuelle barrière de potentiel s'opposant au passage des trous de la couche de Cd_{y}Hg_{1-y}Te à la couche de CdₓHg₁₋ₓTe. Cette gradualité peut être formée lors de la croissance épitaxiale ou par un recuit thermique post-croissance.

La composition de la couche 42 en Cd_{y}Hg_{1-y}Te est telle que la couche est transparente pour les longueurs d'ondes que l'on cherche à détecter : x + ε < y <1, avec ε > 0, où x est la composition de l'alliage CdₓHg₁₋ₓTe qui compose la couche active. Plus précisément on choisit Xₘₐₓ < y, où xₘₐₓ est la composition de l'alliage dont le gap est égal à hc/qλₘᵢₙ (h : constante de Planck ; c : vitesse de la lumière ; q : charge de l' électron ; λₘᵢₙ : longueur d'onde minimale que l'on cherche à détecter), la longueur d'onde maximale à détecter étant définie par le gap de la couche 42 de CdₓHg₁₋ₓTe. De plus, y est préférentiellement choisi inférieur à Xₘₐₓ + 0. 1 afin de conserver un excellent accord de maille entre le substrat 40 en Cd_{1-z}Zn_{z}Te, la couche 42 de Cd_{y}Hg_{1-y}Te et le reste de la structure (zone optiquement active).

L'épaisseur de la couche 42 de Cd_{y}Hg_{1-y}Te est typiquement comprise entre 10 et 30 µm (d'autres épaisseurs sont cependant possibles). Dans une première variante de l'invention cette couche 42 est simplement dopée par écart à la stoechiométrie. Dans une deuxième variante cette couche 42 est dopée extrinsèquement de type P avec une impureté. Préférentiellement une impureté diffusant peu dans CdHgTe, par exemple As ou Sb, est employée. Le dopage P de CdHgTe avec de telles impuretés a été utilisé dans le passé, par exemple dans les documents référencés [4], [5] et [6].

La résistance d'accès aux pixels d'une mosaïque 2D à partir d'un contact substrat situé en bord de mosaïque est considérablement diminuée par l'adjonction de cette couche 42 ; selon l'épaisseur de cette couche et son niveau de dopage (typiquement entre 10¹⁶ et 10¹⁷ cm⁻³, d'une part pour assurer une faible résistance carrée à cette couche, et d'autre part pour éviter une absorption significative par les porteurs libres de la couche du rayonnement que l'on cherche à détecter) une réduction d'un facteur deux à dix, voire plus, de la résistance d'accès aux pixels d'une mosaïque à deux dimensions à partir d'un contact substrat situé en bord de mosaïque peut être obtenue.

La couche 42 de Cd_{y}Hg_{1-y}Te, qui est déposée, n'influe pas sur les caractéristiques électro-optiques des détecteurs élémentaires. En effet cette couche est transparente aux longueurs d'onde que l'on veut détecter et elle est de plus neutre au niveau électrique : la différence de composition y-x qui peut typiquement être choisie comprise entre 0.1 et Xₘₐₓ - x + 0. 1 permet d'assurer une contribution négligeable de la couche 42 de Cd_{y}Hg_{1-y}Te au courant d'obscurité du détecteur à sa température de fonctionnement.

Comme mentionné ci-dessus, l'empilement métallurgique illustré à la figure 3 peut être réalisé par quelque technique d'épitaxie que ce soit. Cependant, à titre d'exemple et de manière non limitative, on peut utiliser l'épitaxie en phase liquide ou l'épitaxie par jets moléculaires qui ont déjà démontré leur capacité à faire croître des empilements multicouches encore plus complexes que ceux demandés ici, comme décrit dans les documents référencés [6] et [7] par exemple. Le procédé technologique pour la fabrication des jonctions N/P détectrices sur ces structures bicouches, décrit dans les documents référencés [1] et [2] peut alors être employé pour obtenir les dispositifs.

Ce concept de diminution de résistance série dans un composant de détection bidimensionnel utilisant un contact- commun, par adjonction d'une couche de grand gap transparente optiquement (et électriquement car de plus grand gap), selon l'invention, est applicable à toute structure de détection (éventuellement à base d'autres semiconducteurs que les alliages CdHgTe, ou à base d'autres éléments de détection que des diodes P/N), hybridée ou non.

Un exemple d'application industrielle du détecteur de l'invention est celui des caméras d'imagerie thermique à base de CdHgTe.

### REFERENCES

[1] « HgCdTe Infrared Diode Arrays » de G.L. Destefanis (Semicond. Sci. Technol., 6, 1991, pages 88-92)
[2] « Hybrid 256 × 256 LWIR FPA Using MBE Grown HgCdTe On GaAs » de A. Kawahara et al. (Proc. SPIE, Vol. 2552, 9-13 juillet 1995, San Diego, pages 411-420)
[3] « Large Improvement In HgCdTe Photovoltaic Detector Performence At LETI » de G. Destefanis, J.P. Chamonal (J. of Electron. Mater., Vol. 22, N° 8, 1993, pages 1027-1032
[4] « HgCdTe MBE Technology : A Focus On Chemical Doping » de O.K. Wu (Mat. Res. Soc. Symp. Proc., vol. 302, 1993, pages 423-431
[5] « Controlled p-Type Sb Doping In LPE Grown Hg₁₋ₓCdₓTe Epilayers » de T.C. Harman (J. of Electron Mater., Vol. 22, N° 9, 1993, pages 1165-1172)
[6] « Hg-Rich Liquid Phase Epitaxy of Hg₁₋ₓCdₓTe » de M.H. Kalisher et al. (Prog. Crystal Growth and Charact., Vol. 29, 1994, pages 41-83)
[7] « Low Threshold Injection Laser In HgCdTe » de P. Bouchut et al. (J. Electron. Mater., Vol. 22, N° 8, 1993, pages 1061-1065)
[8] FR-A-2 612 335
[9] Hg_{0.8}Cd_{0.2}Te grown by liquid phase epitaxy using Cd_{0.94}Zn_{0.06}Te buffer layer" de N.J. Kwak, I.H. choi, S.W. Lim, et S.H. Suh (Journal of Crystal Growth, vol. 138, Nos 1/4, 2 avril 1994, pages 950-955, XP 000474560).

## Revendications

1. Détecteur de rayonnement photonique bidimensionnel basé sur une technique d'hybridation d'une puce de détection sur une puce de lecture via un réseau de microbilles assurant l'interconnexion électrique et mécanique des deux puces, la puce de détection étant constituée d'une structure bidimensionnelle de ixj pixels, une couche active (41) disposée sur un substrat (40), chaque composant élémentaire photosensible consistant en une diode N/P ou P/N réalisée dans la couche active (41), la prise de contact sur la zone N ou P se faisant au niveau de chaque pixel, la prise de contact sur l'autre zone P ou N étant commune à toutes les diodes, **caractérisé en ce qu'**il comprend une couche intermédiaire (42) de plus grand gap que celui de la couche active, cette couche intermédiaire étant transparente optiquement pour les longueurs d'onde que l'on cherche à détecter, et neutre au niveau électrique assurant une contribution négligeable de la couche intermédiaire (42) au couarnt d'obscurité du détecteur cette couche intermédiaire étant déposée sur le substrat (40), la couche active (41) étant déposée sur cette couche intermédiaire (42), la couche active (41) et la couche intermédiaire (42) étant des couches de CdHgTe de composition différentes, la couche intermédiaire étant une couche de Cd_{y}Hg_{1-y}Te telle que y < 1.

2. Détecteur selon la revendication 1, **caractérisé en ce que** la couche active (41) est une couche de CdₓHg₁₋ₓTe, avec 0 ≤ x ≤ 1, **en ce que** le substrat (40) est une couche de Cd_{1-z}Zn_{z}Te, avec 0 ≤ z ≤ 1, et **en ce que** la couche intermédiaire (42) est une couche de Cd_{y}Hg_{1-y}Te transparente pour les longueurs d'onde que l'on cherche à détecter, telle que x + ε < y < 1, avec ε > 0, où x est la composition de l'alliage qui compose la couche active (41).

3. Détecteur selon la revendication 2, **caractérisé en ce que** xₘₐₓ < y, où xₘₐₓ serait la composition d'une couche CdHgTe dont le gap est égal à hc/qλₘᵢₙ avec h : constante de Planck ; c : vitesse de la lumière ; q : charge de l'électron ; λₘᵢₙ : longueur d'onde minimale que l'on cherche à détecter, la longueur d'onde maximale à détecter étant définie par le gap de la couche active (41).

4. Détecteur selon la revendication 3, **caractérisé en ce que** y est inférieur à Xₘₐₓ + 0.1 de manière à conserver un excellent accord de maille entre le substrat (40), la couche intermédiaire (42) et le reste de la structure.

5. Détecteur selon l'une quelconque des revendications précédentes, **caractérisé en ce que** l'épaisseur de la couche intermédiaire (42) est comprise entre 10 et 30 µm.

6. Détecteur selon la revendication 5, **caractérisé en ce que** la couche intermédiaire (42) est dopée par écart à la stoechiométrie.

7. Détecteur selon la revendication 5, **caractérisé en ce que** la couche intermédiaire (42) est dopée extrinsèquement de type P avec une impureté.

8. Détecteur selon la revendication 7, **caractérisé en ce que** cette impureté diffuse peu dans CdHgTe.

9. Détecteur selon la revendication 8, **caractérisé en ce que** cette impureté est de type As ou Sb.

## Patentansprüche

1. Zweidimensionaler Photonstrahlungsdetektor, basierend auf einer Technik zur Hybridisierung eines Detektionschips auf einem Lesechip mittels eines die elektrische und mechanische Verbindung der beiden Chips gewährleistenden Mikrokugelngitters, wobei der Detektionschip gebildet wird durch eine zweidimensionale Struktur aus ixj Pixel, einer auf einem Substrat (40) abgeschiedenen aktiven Schicht (41), wobei jedes photosensible Elementarelement durch eine in der aktiven Schicht (41) realisierten N/P- oder P/N-Diode gebildet wird, die Kontaktnahme auf der N- oder P-Zone bei jedem Pixel erfolgt, die Kontaktnahme auf der anderen P- oder N-Zone allen Dioden gemeinsam ist,
**dadurch gekennzeichnet, dass** er eine Zwischenschicht (42) mit einer größeren Energielücke als derjenigen der aktiven Schicht umfasst, wobei diese Zwischenschicht für die Wellenlängen, die man detektieren will, optisch transparent ist, und elektrisch neutral ist, was einen vernachlässigbaren Beitrag der Zwischenschicht (42) zu dem Dunkelstrom des Detektors gewährleistet, diese Zwischenschicht auf dem Substrat (40) abgeschieden ist, die aktive Schicht (41) auf dieser Zwischenschicht (42) abgeschieden ist, die aktive Schicht (41) und die Zwischenschicht (42) CdHgTe-Schichten mit unterschiedlichen Zusammensetzungen sind, wobei die Zwischenschicht eine Cd_{y}Hg_{1-y}Te-Schicht mit y<1 ist.

2. Detektor nach Anspruch 1, **dadurch gekennzeichnet, dass** die aktive Schicht (41) eine CdₓHg₁₋ₓTe-Schicht mit 0 ≤ x ≤ 1 ist, dass das Substrat (40) eine Cd_{1-z}Zn_{z}Te-Schicht mit 0 ≤ z ≤ 1 ist, und dass die Zwischenschicht (42) eine für diejenigen Wellenlängen transparente Cd_{y}Hg_{1-y}Te-Schicht ist, die man detektieren will, so dass x + e < y < 1, mit ε > 0, wo x die Zusammensetzung der Legierung ist, die die aktive Schicht (41) bildet.

3. Detektor nach Anspruch 2, **dadurch gekennzeichnet, dass** xₘₐₓ < y, wo xₘₐₓ die Zusammensetzung einer CdHgTe-Schicht wäre, deren Energielücke gleich hc/qλₘᵢₙ ist, mit h: Planck-Konstante; c: Lichtgeschwindigkeit; q: Elektronenladung; λₘᵢₙ: minimale Wellenlänge, die man detektieren will, wobei die zu detektierende maximale Wellenlänge durch die Energielücke der aktiven Schicht (41) definiert wird.

4. Detektor nach Anspruch 3, **dadurch gekennzeichnet, dass** y kleiner als Xₘₐₓ + 0.1 ist, um eine exzellente Kristallgitterübereinstimmung zwischen dem Substrat (40), der Zwischenschicht (42) und der restlichen Struktur zu erreichen.

5. Detektor nach einem der vorangehenden Ansprüche, **dadurch gekennzeichnet, dass** die Dicke der Zwischenschicht (42) zwischen 10 und 30 µm enthalten ist.

6. Detektor nach Anspruch 5, **dadurch gekennzeichnet, dass** die Zwischenschicht (42) dotiert wird durch Abweichen von der Stöchiometrie.

7. Detektor nach Anspruch 5, **dadurch gekennzeichnet, dass** die Zwischenschicht (42) extrinsisch mit Typ P mit einer Verunreinigung dotiert wird.

8. Detektor nach Anspruch 7, **dadurch gekennzeichnet, dass** diese Verunreinigung nur wenig in CdHgTe diffundiert.

9. Detektor nach Anspruch 8, **dadurch gekennzeichnet, dass** diese Verunreinigung vom Typ As oder Sb ist.

## Claims

1. Two-dimensional photonic radiation detector based on a technique of hybridizing a detection chip onto a read chip through a micro-balls network making the electrical and mechanical interconnection between two chips, the detection chip being composed of a two-dimensional structure of ixj pixels, an active layer being epitaxed onto a substrate, each elementary photosensitive component consisting of an N/P or P/N diode formed in the active layer, the contact point on the N or P area being made at each pixel, the contact point on the other P or N area being common to all diodes, **characterized in that** it comprises an intermediate layer with a larger gap than that of the active layer, said intermediate layer being optically transparent for wavelengths which it is wished to detect and neutral from the electrical standpoint, ensuring a negligible contribution of the intermediate layer to the dark current of the detector, said intermediate layer being deposited on the substrate, the active layer being deposited on said intermediate layer, the active layer and the intermediate layer being CdHgTe layers of different composition, the intermediate layer being a Cd_{y}Hg_{1-y}Te layer such that y < 1.

2. Detector according to claim 1, **characterized in that** the active layer (41) is a layer of CdₓHg₁₋ₓTe, where 0 ≤ x ≤ 1, **in that** the substrate (40) is a layer of Cd_{1-z}Zn_{z}Te, where 0 ≤ z ≤ 1 and **in that** the intermediate layer (42) is a layer of Cd_{y}Hg_{1-y}Te transparent for the wavelength to be detected, such that x + ε < y < 1, where ε > 0, where x is the composition of the alloy that makes up the active layer (41).

3. Detector according to claim 2, **characterized in that** xₘₐₓ < y, where xₘₐₓ would be the composition of a CdHgTe layer with a gap equal to hc/qλₘᵢₙ (h = Planck's constant, c = speed of light, q = electron charge, λₘᵢₙ = minimum wavelength to be detected), the maximum wavelength to be detected being defined by the gap in the active layer (41).

4. Detector according to claim 3, **characterized in that** y is less than xₘₐₓ + 0.1 in order to maintain an excellent mesh match between the substrate (40), the intermediate layer (42) and the rest of the structure.

5. Detector according to anyone of the previous claims, **characterized in that** the thickness of the intermediate layer (42) is between 10 and 30 µm.

6. Detector according to claim 5, **characterized in that** the intermediate layer (42) is doped to differ from stoichiometry.

7. Detector according to claim 5, **characterized in that** the intermediate layer (42) is extrinsically P type doped with an impurity.

8. Detector according to claim 7, **characterized in that** this impurity diffuses little in CdHgTe.

9. Detector according to claim 8, **characterized in that** this impurity is of the As or Sb type.
